(19) Europäisches Patentamt
European Patent Office
Office européen des brevets

(11) EP 1 742 109 A2

(12) **EUROPEAN PATENT APPLICATION**

(43) Date of publication:
**10.01.2007 Bulletin 2007/02**

(51) Int Cl.:
***G03F 7/11*** *(2006.01)*

(21) Application number: **06014163.7**

(22) Date of filing: **07.07.2006**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **07.07.2005 JP 2005198859**

(71) Applicant: **Fuji Photo Film Co., Ltd.**
**Minami-Ashigara-shi, Kanagawa (JP)**

(72) Inventor: **Hoshi, Satoshi**
**Haibara-gun**
**Shizuoka (JP)**

(74) Representative: **HOFFMANN EITLE**
**Patent- und Rechtsanwälte**
**Arabellastrasse 4**
**81925 München (DE)**

(54) **Hydrophilic substrate for lithographic printing plate**

(57) A hydrophilic substrate comprising: a hydrophilic layer; and a support, wherein the hydrophilic layer contains a hydrophilic particle having a surface area of from 1 to 1,000 $m^2/g$.

EP 1 742 109 A2

## Description

### FIELD OF THE INVENTION

The present invention relates to a hydrophilic substrate for lithographic printing plate. More specifically, it relates to a hydrophilic substrate for lithographic printing plate having a novel hydrophilic layer, a lithographic printing plate precursor using the hydrophilic substrate, and a lithographic printing method using the hydrophilic substrate.

### BACKGROUND OF THE INVENTION

As a hydrophilic substrate for lithographic printing plate, an anodized aluminum substrate has been conventionally used. It is also practiced to treat the anodized aluminum substrate with an undercoating agent (for example, silicate, polyvinyl sulfonic acid or polyvinyl benzoic acid) in order to increase the hydrophilicity. Further, a technique of using a polymer having a sulfonic acid group in an undercoat layer (hydrophilic layer) is proposed (see, for example, JP-A-59-101651 (the term "JP-A" as used herein means an "unexamined published Japanese patent application")).
In place of a metallic support such as aluminum support, a support comprising a polymer film, for example, a polyethylene terephthalate film or cellulose acetate film is also proposed. On the polymer film support, it is necessary to provide a hydrophilic layer. As the hydrophilic layer provided on the polymer film support, there are known a swellable hydrophilic layer (see, for example, JP-A-8-292558), a hydrophilic swellable layer comprising a hydrophilic polymer and a crosslinking agent (see, for example, JP-A-9-218507), and a hydrophilic layer comprising a hydrophilic polymer cured with a hydrolyzed tetra-alkyl ortho silicate (see, for example, JP-A-8-272087). Further, as the polymer film support having a hydrophilic surface, a polyethylene terephthalate support having a microporous hydrophilic crosslinked silicate surface (see, for example, JP-A-8-192579) is also proposed.

### SUMMARY OF THE INVENTION

When a hitherto known hydrophilic layer is used in a lithographic printing plate, prints without the formation of stain can be obtained under good printing conditions. However, a lithographic printing plate which has a hydrophilic layer of higher hydrophilicity and provides prints without the formation of stain even under severe printing conditions has been desired.
An object of the present invention is to provide a hydrophilic substrate for lithographic printing plate which provides prints having extremely low stain even under severe printing conditions.
The present invention includes the following items.

1. A hydrophilic substrate comprising a hydrophilic layer and a support, wherein the hydrophilic layer contains a hydrophilic particle having a surface area from 1 to 1,000 $m^2$/g.
2. The hydrophilic substrate as described in 1 above, wherein a moisture adsorption amount of the hydrophilic particle is 100% or less at relative humidity of 90%.
3. The hydrophilic substrate as described in 1 above, wherein a moisture adsorption amount of the hydrophilic layer is 100% or less at relative humidity of 90%.
4. A lithographic printing plate precursor comprising the hydrophilic substrate as described in any one of 1 to 3 above, wherein the hydrophilic layer contains a hydrophilicity-hydrophobicity converting agent which functions upon acceptance of light or heat energy.
5. A lithographic printing plate precursor comprising an image-recording layer capable of being removed with ink and/or dampening water on the hydrophilic substrate as described in any one of 1 to 3 above.
6. A lithographic printing method comprising the steps of:

    (1) attaching a hydrophobic substance onto the hydrophilic substrate as described in any one of 1 to 3 above in response to an image to prepare a lithographic printing plate comprising a hydrophilic region composed of the hydrophilic surface of the hydrophilic substrate and a hydrophobic region composed of the hydrophobic substance attached; and
    (2) supplying dampening water and ink to the lithographic printing plate to conduct printing.

In the lithographic printing, difference between the hydrophilicity in the non-image area and the hydrophobicity in the image area is most important. It has been thought, therefore, that good prints can be obtained in the lithographic printing by increasing the hydrophilicity of the hydrophilic layer.
However, as a result of the investigations by the inventor, it has been found that when the hydrophilicity is increased by enhancing swelling property of the hydrophilic layer or constructing a porous layer according to hitherto

known techniques, an amount of dampening water in the hydrophilic layer increases and consequently an amount of the dampening water attached on the hydrophilic layer decreases, whereby good prints can not be obtained. In other words, it becomes clear that the amount of dampening water on the hydrophilic region (and the amount of dampening water which the hydrophilic layer can absorb) at the printing affects quality of the prints.

Further, the hydrophilic layer for use in the lithographic printing plate precursor is preferably not a layer having only high hydrophilicity but a layer hardly absorbs water. It has been found that the addition of particle having a small surface area and a small moisture absorption amount is effective in order to obtain such a hydrophilic layer. The mode of action on the effectiveness of this means is believed to be that since an amount of dampening water which the hydrophilic layer absorbs is small, the surplus water is apt to exist on the surface region of the hydrophilic layer even under the severe conditions where the supply of dampening water is small.

According to the present invention, a lithographic printing plate which provides prints having extremely low stain even under severe printing conditions can be provided.

## DETAILED DESCRIPTION OF THE INVENTION

### [Hydrophilic particle]

The hydrophilic particle incorporated into the hydrophilic layer is broadly classified into an organic particle and an inorganic particle.

The organic particle preferably comprises a polymer. The polymer is preferably crosslinked. The organic particle may have a core/shell structure (including a microcapsule). The surface of the organic particle is preferably hydrophilic. Specifically, the organic particle has such surface hydrophilicity that it can be dispersed in water.

The organic particle can be synthesized by an emulsion polymerization method. Micro gel described in JP-A-5-254251 is organic particle prepared by the emulsion polymerization method. According to the emulsion polymerization method, a monomer is subjected to emulsion polymerization using an emulsifying agent containing a group (preferably two or more groups) having a carbon-carbon double bond in its molecule.

Examples of the monomer include an alkyl acrylate, an alkyl methacrylate, styrene and a styrene derivative. Examples of the group having a carbon-carbon double bond contained in the emulsifying agent include vinyl, allyl, 1-propenyl, 2-methyl-1-propenyl, isopropenyl, acryloyl and methacryloyl groups. Among them, acryloyl and methacryloyl groups are preferable.

The emulsifying agent contains a hydrophilic group in addition to the group having a carbon-carbon double bond. Examples of the hydrophilic group include a carboxylic acid group and a salt thereof, a sulfuric ester group and a salt thereof, an amino group, a substituted amino group, a hydroxy group, a phosphoric acid group and a salt thereof and a polyoxyalkylene group (for example, polyoxyethylene or polyoxypropylene) . The counter cation for the carboxylic acid group, sulfuric ester group or phosphoric acid group is preferably an alkali metal (for example, sodium or potassium) . The substituent for the substituted amino group is preferably an alkyl group, an aralkyl group or a hydroxyalkyl group, and more preferably an alkyl group or a hydroxyalkyl group. The hydrophilic group is preferably a substituted amino group.

The emulsifying agent containing a carbon-carbon double bond has a function of a polymerizable (crosslinkable) monomer in addition to the function of a usual emulsifying agent. Therefore, by using the emulsifying agent described above, a hydrophilic group derived from the emulsifying agent can be introduced on the surface of polymer fine particle. The hydrophilic group may also be introduced into the inside of the polymer fine particle by appropriately selecting the kind and amount of the emulsifying agent and the reaction method used.

Examples of the emulsifying agent include a sulfosuccinic ester salt of polyoxyethylene alkyl ether containing two or more carbon-carbon double bonds in its molecule, a sulfuric ester salt of polyoxyethylene alkyl ether containing two or more carbon-carbon double bonds in its molecule, a sulfosuccinic ester salt of polyoxyethylene alkyl phenyl ether containing two or more carbon-carbon double bonds in its molecule, a sulfuric ester salt of polyoxyethylene alkyl phenyl ether containing two or more carbon-carbon double bonds in its molecule, an acidic phosphoric acid (meth)acrylic acid ester type dispersing agent, a phosphoric ester of oligo ester (meth)acrylate and an alkali salt thereof and an oligo ester poly (meth) acrylate of polyalkylene glycol derivative having a hydrophilic alkylene oxide group. Also, a commercially available emulsifying agent, for example, Kayamer PM-2, produced by Nippon Kayaku Co., Ltd., New Frontier A-229E, produced by Dai-Ichi Kogyo Seiyaku Co., Ltd., or New Frontier N-250Z, produced by Dai-Ichi Kogyo Seiyaku Co.) may be used.

The emulsifying agent containing a carbon-carbon double bond may be used together with other emulsifying agent (for example, an anionic surfactant, cationic surfactant or nonionic surfactant). An amount of the emulsifying agent added is preferably from 1 to 20 parts by weight, more preferably from 3 to 10 parts by weight, based on 100 parts by weight of the monomer.

According to the emulsion polymerization method, the polymer fine particle can be obtained by charging the emulsifying agent and water in a reaction vessel, adding a monomer, followed by emulsification, adding a radical polymerization initiator, and heating with stirring to polymerize the monomer. The monomer may be added not at a time but dividedly at several times. An amount of each component is controlled to have concentration of solid content preferably from 20 to 50% by weight, more preferably from 30 to 45% by weight, in the reaction solution (dispersion solution) finally obtained. A pH at the reaction is preferably from 3 to 9. A temperature of the reaction is preferably from 40 to 90°C, more preferably from 50 to 80°C. A time for the reaction is preferably from 30 minutes to 2 hours.

The radical polymerization initiator is preferably a persulfate (for example, potassium persulfate or ammonium persulfate), hydrogen peroxide, a water-soluble azo compound or a redox type polymerization initiator. A redox type polymerization initiator is preferable. The redox type polymerization initiator comprises a combination of a persulfate with a reducing agent (for example, sodium hydrogen sulfite or sodium thiosulfate). An amount of the radical polymerization initiator added is preferably from 0.05 to 5% by weight, more preferably from 0.1 to 3% by weight, based on the total amount of the monomer.

The polymerization reaction is preferably carried out in the presence of a polymerization accelerator (for example, a transition metal ion).

Further, the organic fine particle may comprise calcium alginate.

As the inorganic particle, a particle of oxide or hydroxide of an element selected from beryllium, magnesium, aluminum, silicon, titanium, boron, germanium, tin, zirconium, iron, vanadium, antimony and a transition metal can be used. Particularly, the particle of oxide or hydroxide of an element selected from magnesium, aluminum, silicon, titanium and iron is preferable.

The hydrophilic particle according to the invention has a surface area from 1 to 1,000 $m^2/g$. The surface area of the hydrophilic particle is preferably from 2 to 700 $m^2/g$, most preferably from 4 to 500 $m^2/g$. The surface area of the hydrophilic particle can be determined by measuring an adsorption amount of inert gas using the BET method. When the surface area of the hydrophilic particle exceeds 1,000 $m^2/g$, the moisture adsorbed in the hydrophilic particle becomes large and printing stain may be apt to occur.

The moisture adsorption amount of the hydrophilic particle according to the invention is preferably 100% by weight or less, more preferably 70% by weight or less, based on the weight of the particle at relative humidity of 90%. When the moisture adsorption amount of the hydrophilic particle exceeds 100% by weight, the moisture adsorbed in the hydrophilic layer becomes large and printing stain may be apt to occur.

The moisture adsorption amount of the hydrophilic particle can be determined based on change in the weight thereof after standing under an environment of 25°C temperature and 90% humidity for one hour from the weight thereof under a dry condition (relative humidity of 10%).

(Moisture adsorption amount of hydrophilic particle)

Weight (P1) of the hydrophilic particle after humidity conditioning under an environment of 25°C temperature and 10% humidity for one hour and weight (P2) of the hydrophilic particle after humidity conditioning under an environment of 25°C temperature and 90% humidity for one hour are measured respectively and the difference of (P2) - (P1) is regarded as an amount of moisture adsorbed in the hydrophilic particle. The moisture adsorption amount (%) is calculated from a ratio of the amount of moisture adsorbed in the hydrophilic particle to the weight of the hydrophilic particle after humidity conditioning under an environment of 25°C temperature and 10% humidity for one hour as follows:

$$\text{The moisture adsorption amount (\%)} = [(P2)-(P1)]/(P1) \times 100 \ (\%)$$

A particle size of the hydrophilic particle is preferably from 2 nm to 10 μm, more preferably from 5 nm to 5 μm, in the invention. Further, acicular alumina particle of 100 nm x 10 nm and pearl necklace-like structure of silica particles rowed are also effective.

An amount of the hydrophilic particle added is preferably from 0.1 to 70% by weight, particularly preferably from 1 to 50% by weight, based on the total solid content of the hydrophilic layer. When the amount added is too small under the above-described range, the moisture adsorption amount of the hydrophilic layer becomes large and printing stain may be apt to occur. When the amount added is too large over the above-described range, layer strength decreases and sufficient printing durability may not be obtained.

[Hydrophilic layer]

The hydrophilic layer is broadly classified into two groups: an embodiment of a hydrophilic image-recording

layer that can be changed into hydrophobic and an embodiment wherein the hydrophilic layer and a support construct a hydrophilic substrate.

According to the embodiment of a hydrophilic image-recording layer that can be changed into hydrophobic, a construction including the hydrophilic image-recording layer and a support functions as a lithographic printing plate precursor by incorporating a hydrophilicity-hydrophobicity converting agent into the hydrophilic image-recording layer.

According to the embodiment wherein the hydrophilic layer and a support construct a hydrophilic substrate, a lithographic printing plate precursor is obtained by providing an image-recording layer on the hydrophilic layer, or a lithographic printing plate is directly prepared by directly forming a hydrophobic region (for example, imagewise supplying hydrophobic oil droplets by an inkjet system) on the hydrophilic layer.

The present invention is effective in either embodiment.

The moisture adsorption amount of the hydrophilic layer according to the invention is preferably 100% by weight or less at relative humidity of 90%. Specifically, the moisture adsorption amount of the hydrophilic layer at relative humidity of 90% is preferably 100% by weight or less based on the weight of the hydrophilic layer per $m^2$ in the dried state. The moisture adsorption amount of the hydrophilic layer is more preferably 80% by weight or less and still more preferably 70% by weight or less. In the above-described range, the hydrophilic layer exhibiting better stain resistance is obtained.

The moisture adsorption amount of the hydrophilic layer can be measured and calculated in the following manner.

(Moisture adsorption amount of hydrophilic layer)

Weight (A1) of a sample of the hydrophilic layer after humidity conditioning under an environment of 25°C temperature and 10% humidity for one hour is measured as the weight in the dried state. Then, weight (A2) of a sample of the hydrophilic layer after humidity conditioning under an environment of 25°C temperature and 90% humidity for one hour is measured and the difference of (A2) - (A1) is regarded as the amount of moisture adsorbed in the hydrophilic layer. The moisture adsorption amount (%) is calculated from a ratio of the amount of moisture adsorbed in the hydrophilic layer to weight (T) g per $m^2$ of the hydrophilic layer after humidity conditioning under an environment of 25°C temperature and 10% humidity for one hour as follows:

$$\text{The moisture adsorption amount (\%)} = [(A2)-(A1)]/T \times 100\ (\%)$$

According to the invention, it is preferred to construct the hydrophilic layer as a layer hardly absorbs water as described above. Specifically, in order to form the layer hardly absorbs water, in addition to (1) method of incorporating the specific hydrophilic particle as filler into the hydrophilic layer, (2) method of crosslinking in the high density a hydrophilic polymer constituting the hydrophilic layer, (3) method of forming a layer having physical properties close to glass by sol-gel conversion or (4) method of graft-polymerizing a hydrophilic polymer constituting the hydrophilic layer is adopted. The above-described methods (1) to (4) may be used in combination.

(Method of crosslinking in the high density a hydrophilic polymer)

The hydrophilic polymer before crosslinking is a known hydrophilic polymer.

As the hydrophilic polymer, a synthetic polymer is preferable rather than a natural polymer (for example, a polysaccharide or protein) or a semi-synthetic polymer (for example, a starch derivative, cellulose ether or cellulose ester). Examples of the polysaccharide include gum arabic, sodium alginate, hyaluronic acid and dextrin. Examples of the protein include casein and gelatin. Examples of the cellulose ether include carboxymethyl cellulose and a sodium salt thereof and hydroxyethyl cellulose. Examples of the cellulose ester include cellulose acetate.

The main chain of the hydrophilic polymer is preferably hydrocarbon, halogenated hydrocarbon, polyester, polyamide (for example, alcohol-soluble nylon), polyamine, polyether (for example, polyoxyethylene or polyether of 2,2-bis(4-hydroxyphenyl)propane and epichlorohydrin), polyurethane, polyurea or a combination thereof, more preferably hydrocarbon, polyether, polyurethane, polyurea or a combination thereof, and most preferably hydrocarbon.

The hydrophilic polymer preferably has a hydrophilic group as the side chin or main chain thereof or a substituent for the side chain. The hydrophilic group is preferably a carboxylic acid group, an amino group, a phosphoric acid group, a sulfonic acid group, a hydroxy group, an amido group or a polyoxyalkylene group (for example, polyoxyethylene), more preferably a carboxylic acid group, an amino group, a sulfonic acid group, a hydroxy group, an amido group or a polyoxyalkylene group.

The carboxylic acid group, phosphoric acid group or sulfonic acid group may be in the form of an anion or salt. The counter cation of the carboxylic acid group is preferably an ammonium ion or an alkali metal ion. The counter cation of the sulfonic acid group is preferably an ammonium ion, an alkali metal ion or an alkaline earth metal ion.

The amino group may be in the form of a cation (an ammonium group) or salt. The counter anion of the amino group is preferably a halide ion.

The hydrophilic polymer is preferably a polymer of an ethylenically unsaturated monomer having a hydrophilic group. Examples of the ethylenically unsaturated monomer having a hydrophilic group include (meth) acrylic acid and a salt thereof, itaconic acid and a salt thereof , maleic acid and a salt thereof, 2-hydroxyethyl (meth)acrylate, hydroxypropyl (meth)acrylate, hydroxybutyl (meth)acrylate, (meth) acrylamide, N-monomethylol(meth)acrylamide, N,N-dimethylol (meth)acrylamide, 3-vinylpropnionic acid and a salt thereof, vinylsulfonic acid and a salt thereof, 2-sulfoethyl (meth) acrylate and a salt hereof, polyoxyethylene glycol mono(meth)acrylate, 2-acrylamido-2-methylpropanesulsonic acid and a salt thereof, phosphoxypolyoxyethylene glycol mono (meth) acrylate and a salt thereof, allylamine and hydroxypropylene. Further, polyvinyl alcohol, polyvinyl formal, polyvinyl butyral and polyvinyl pyrrolidone are included in the polymer of an ethylenically unsaturated monomer having a hydrophilic group. A saponification degree of the polyvinyl alcohol is preferably 60% by weight or more, more preferably 80% by weight or more.

The hydrophilic polymer may be a homopolymer of the ethylenically unsaturated monomer having a hydrophilic group. The hydrophilic polymer may be a copolymer of two or more of the ethylenically unsaturated monomers having a hydrophilic group. The hydrophilic polymer may be a copolymer of the ethylenically unsaturated monomer having a hydrophilic group and other ethylenically unsaturated monomer (which does not have a hydrophilic group).

Examples of the other ethylenically unsaturated monomer include vinyl acetate and styrene. Examples of the copolymer include a vinyl acetate-maleic acid copolymer and a styrene-maleic acid copolymer.

Two or more hydrophilic polymers may be used in combination.

The crosslinking structure can be introduced into the hydrophilic polymer by (1-1) method of introducing a crosslinkable group into the hydrophilic polymer and reacting the crosslinkable group, or (1-2) method of reacting the hydrophilic group of the hydrophilic polymer with a crosslinking agent.

According to (1-1) the method of introducing a crosslinkable group into the hydrophilic polymer and reacting the crosslinkable group, a compound having a group reacting with the hydrophilic group and a crosslinkable group is reacted with the hydrophilic polymer. The crosslinkable group is preferably an ethylenically unsaturated group (for example, a vinyl, allyl, acryloyl, or methacryloyl group) or a ring-forming group (for example, a cinnamoyl, cinnamilidene, cyanocinnamilidene or p-phenylenediacrylate group).

In the crosslinking reaction of the crosslinkable group, it is preferred to use a monomer having a functional group reacting with the crosslinkable group (functional group same as the crosslinkable group) . In the crosslinking reaction, it is preferred to use a polymerization initiator (described hereinafter). It is preferred that the crosslinking reaction of the ethylenically unsaturated group or ring-forming group is conducted after or simultaneously with drying of the hydrophilic layer formed on a support by coating.

According to (1-2) the method of reacting the hydrophilic group of the hydrophilic polymer with a crosslinking agent, a crosslinking agent having multiple functional groups having reactivity with the hydrophilic group is used.

The crosslinking agent is ordinarily a compound capable of forming crosslinking between the polymers upon heat or light. The crosslinking agent is described in Sinzo Yamashita and Tosuke Kaneko, Kakyozai Handbook (Handbook of Crosslinking Agents), Taiseisha Ltd. (1981).

The reactive group of the crosslinking agent is preferably a carboxy group or a salt thereof, a carboxylic acid anhydride group, an amino group, an imino group, a hydroxy group, an epoxy group, an aldehyde group, a methylol group, a mercapto group, an isocyanate group, a blocked isocyanate group, an alkoxysilyl group, an ethylenically unsaturated double bond group, a coordinate linkage group, an ester bond group or a tetrazole group.

Examples of the crosslinking agent having a carboxy group as the reactive group include an α, ω-alkanedicarboxylic acid (for example, succinic acid or adipic acid), an α, ω-alkenedicarboxylic acid and a polycarboxylic acid (for example, 1,2,3-propanetricarboxylic acid, 1,2,3,4-butanetetracarboxylic acid, trimellitic acid or polyacrylic acid).

Examples of the crosslinking agent having an amino group or imino group as the reactive group include an amine (for example, butylamine, spermin, diaminocyclohexane, piperadine, aniline, phenylenediamine, 1,2-ethanediamine, diethylenediamine or diethylenetriamine) and an imine (for example, polyethyleneimine).

Examples of the crosslinking agent having an epoxy group as the reactive group include a polyepoxy compound (for example, ethylene glycol diglycidyl ether, propylene glycol diglycidyl ether, tetraethylene glycol diglycidyl ether, nonaethylene glycol diglycidyl ether, polyethylene glycol diglycidyl ether, polypropylene glycol diglycidyl ether, neopentyl glycol diglycidyl ether, 1,6-hexanediol diglycidyl ether, trimethylolpropane triglycidyl ether or sorbitol polydiglycidyl ether).

Examples of the crosslinking agent having a hydroxy group as the reactive group include an alkylene glycol (for example, ethylene glycol or propylene glycol), an oligoalkylene glycol (for example, diethylene glycol or tetraethylene glycol), a polyalkylene glycol, a polyol (for example, trimethylolpropane, glycerin, pentaerythritol, sorbitol or polyvinyl alcohol).

Examples of the crosslinking agent having an aldehyde group as the reactive group include a polyaldehyde (for example, glyoxal or terephthalaldehyde).

Examples of the crosslinking agent having an isocyanate group or blocked isocyanate group as the reactive group include a polyisocyanate (for example, tolylene diisocyanate, hexamethylene diisocyanate, diphenylmethane isocyanate, xylylene diisocyanate, polymethylene polyphenyl isocyanate, cyclohexyl diisocyanate, cyclohexane phenylene diisocyanate, naphthalene-1,5-diisocyanate, isopropylbenzene-2,4-diisocyanate or polypropylene glycol/tolylene dicyanate addition reaction product) and a blocked polyisocyanate compound.

Examples of the crosslinking agent having an alkoxysilyl group as the reactive group include a silane coupling agent (for example, tetraalkoxysilane).

Examples of the crosslinking agent having a coordinate linkage group as the reactive group include a metallic crosslinking agent (for example, aluminum acetylacetonate, copper acetylacetonate or iron (III) acetylacetonate).

Examples of the crosslinking agent having a methylol group as the reactive group include a polymethylol compound (for example, trimethylol melamine or pentaerythritol).

Examples of the crosslinking agent having a mercapto group as the reactive group include a polythiol compound (for example, dithioerythritol, pentaerythritol tetrakis(2-mercaptoacetate) or trimethylolpropane tris(2-mercaptoacetate)).

(Method of forming a layer having physical properties close to glass by sol-gel conversion)

In the case of forming a layer having physical properties close to glass by sol-gel conversion, the hydrophilic polymer comprises preferably a system of a metal hydroxide and a metal oxide, more preferably a sol-gel conversion system forming gel composition of polysiloxane. The sol-gel conversion system is described in JP-A-2003-175683.

The sol-gel conversion system comprises a polymer having resinous structure where a bonding group of a polyvalent element forms a network structure through an oxygen atom and the polyvalent element also has an unbound hydroxy group and alkoxy group. In the stage where a large number of the hydroxy group and alkoxy group is present before coating, the system is a sol state. On the other hand, after the coating, the network resinous structure becomes strong with the proceeding of esterification reaction and the system forms a gel state.

The polyvalent element for the sol-gel conversion system is preferably aluminum, silicon, titanium or zirconium. The sol-gel conversion system comprising silicon, specifically, a siloxane bonding is most preferable.

Examples of the silane compound used in the sol-gel conversion system include tetrachlorosilane, tetrabromosilane, tetramethoxysilane, tetraethoxysilane, tetraisopropoxysilane, tetrabutoxysilane, dimethoxydiethoxysilane, triethoxysilane, tribromosilane, trimethoxysilane, triisopropoxysilane and tri(tert-butoxy)silane.

In addition to the silane compound, other metallic compound may be used together. Examples of the metal element in the metallic compound include Ti, Zn, Sn, Zr and Al. Examples of the metallic compound include $Ti(OR)_4$, $TiCl_4$, $Zn(OR)_2$, $Zn(CH_3COCHCOCH_3)_2$, $Sn (OR)_4$, $Sn (CH_3COCHCOCH_3)_4$, $Sn (OCOR)_4$, $SnCl_4$, $Zr(OR)_4$, $Zr (CH_3COCHCOCH_3)_4$ and $Al (OR)_3$, wherein R represents an alkyl group having from 1 to 6 carbon atoms.

To the matrix of gel structure may be added a hydrophilic polymer having a functional group corresponding to a silane coupling agent at the terminal thereof or a crosslinking agent. The hydrophilic polymer having a functional group corresponding to a silane coupling agent at the terminal thereof (described in JP-A-2003-175683) is presented by the following formula:

$$(R-)_m(RO-)_{3-m}Si- (CH_2)_n-S- (CHR-CR (-L-Y))_p-$$

In the formula, represents a hydrogen atom or a hydrocarbon group having from 1 to 8 carbon atoms, m represents 0, 1 or 2, n represents an integer from 1 to 8, p represents an integer from 30 to 300, L represents a single bond or a divalent connecting group, Y represents $-NHCOCH_3$, $-CONH_2$, $-CON(CH_3)_2$, $-COCH_3$, $-OCH_3$, -OH, $-CO_2M$ or $-CONHC(CH_3)_2SO_3M$, M represents a counter cation selected from the group consisting of a proton, an alkali metal ion, an alkaline earth metal ion and an onium ion. The divalent connecting group preferably comprises 1 to 60 carbon atoms, 0 to 10 nitrogen atoms, 0 to 50 oxygen atoms, 1 to 100 hydrogen atoms and 0 to 20 surfer atoms.

The sol-gel conversion using aluminum, titanium or zirconium can be conducted by replacing the silicon described above with aluminum, titanium or zirconium.

(Method of graft-polymerizing a hydrophilic polymer constituting the hydrophilic layer)

In the method of graft-polymerizing, a hydrophilic polymer having a reactive group at only one terminal of the main chain or side chain thereof is used. The hydrophilic polymer having a reactive group at only one terminal of the main chain thereof is preferable. The term "reactive group" as used herein means a functional group capable of reacting with a chemical bond agent to form a chemical bond and it is a relative concept determined in relation to a reactive group of the chemical bond agent. It is preferred that the hydrophilic polymer is water-soluble and becomes water-insoluble

upon the reaction with the chemical bond agent.

The chemical bond includes a covalent bond, an ionic bond, a coordinate and a hydrogen bond, same as in the usual sense. The chemical bond is preferably a covalent bond.

The reactive group is ordinarily same as the reactive group included in the crosslinking agent for a polymer. Details of the chemical bond agent are same as those of the crosslinking agent described above.

Examples of the reactive group include a carboxy group (HOOC-), a salt thereof (MOOC-, wherein M represents a cation), a carboxylic acid anhydride group (for example, a monovalent group derived from succinic anhydride, phthalic anhydride or maleic anhydride), an amino group ($H_2N$-), a hydroxy group (HO-), an epoxy group (for example, 1, 2-epoxyethyl group), a methylol group (HO-$CH_2$-), a mercapto group (HS-), an isocyanate group (OCN-), a blocked isocyanate group, an alkoxysilyl group, an ethylenically unsaturated double bond group, an ester bond group and a tetrazole group. Two or more reactive groups may be present at one terminal. Two or more reactive groups may be different from each other.

It is preferred that a linking group mediates between the repeating unit and the reactive group of the hydrophilic polymer. The linking group is preferably selected from -O-, -S-, -CO-, -NH-, -N<, an aliphatic group, an aromatic group, a heterocyclic group and a combination thereof. The linking group is more preferably -O-, -S- or a combination including -O- or -S-, and still more preferably -O- or -S-.

The main chain of hydrophilic polymer and hydrophilic group are same as those described in the method of crosslinking in the high density a hydrophilic polymer described above.

A linking group may mediate between the main chain and the hydrophilic group of the hydrophilic polymer. The linking group is preferably selected from -O-, -S-, -CO-, -NH-, -N<, an aliphatic group, an aromatic group, a heterocyclic group and a combination thereof.

The hydrophilic polymer having a reactive group at one terminal of the main chain thereof can be synthesized, for example, by radical polymerization of a hydrophilic monomer (for example, acrylamide, acrylic acid or potassium salt of 3-sulfopropyl methacrylate) in the presence of a chain transfer agent (as described in Mikiharu Kamachi and Tsuyoshi Endo, Radical Jyugo Handbook (Handbook of Radical Polymerization), NTS Inc.) or an iniferter (as described in Otsu et al., Macromolecules, 19, pp. 2087 (1986)). Examples of the chain transfer agent include 3-mercaptopropionic acid, 2-aminoethanethiol hydrochloride, 3-mercaptopropanol and 2-hydroxyethyldisulfide. Further, a hydrophilic monomer (for example, acrylamide) may be subjected to radical polymerization using a radical polymerization initiator having a reactive group (for example, carboxy group) without using the chain transfer agent.

Weight average molecular weight of the hydrophilic polymer having a reactive group at one terminal of the main chain thereof is preferably 1,000,000 or less, more preferably from 1,000 to 1,000,000, and most preferably from 10,000 to 70,000.

When the reactive group present at one terminal of the hydrophilic polymer is a carboxy group or a salt thereof, it is preferred to use as the chemical bond agent, a polyepoxy compound, a polyamine compound, a polymehtylol compound, a polyisocyanate compound, a blocked polyisocyanate compound or a metallic crosslinking agent.

When the reactive group present at one terminal of the hydrophilic polymer is a methylol group, a phenolic hydroxy group or a glycidyl group, it is preferred to use as the chemical bond agent, a polycarboxylic acid compound, a polyamine compound or a polyhydroxy compound.

When the reactive group present at one terminal of the hydrophilic polymer is an amino group, a polyisocyanate compound, a blocked polyisocyanate compound, a polyepoxy compound or a polymehtylol compound can be used as the chemical bond agent. When the reactive group present at one terminal of the hydrophilic polymer is a hydroxy group, a polyisocyanate compound, a blocked polyisocyanate compound, a polyaldehyde compound or a polycarboxylic acid compound can be used as the chemical bond agent.

When the reactive group present at one terminal of the hydrophilic polymer is an alkoxysilyl group, a tetraalkoxysilane or a polyhydric alcohol can be used as the chemical bond agent.

When the reactive group present at one terminal of the hydrophilic polymer is an ethylenically unsaturated double bond group, a polythiol compound, an amine or an imine can be used as the chemical bond agent.

In the reaction between the chemical bond agents, a reaction between epoxy groups is also utilized in addition to the reactions between the hydrophilic polymer and the chemical bond agent described above.

The reactive group at one terminal of the hydrophilic polymer is chemically bonded with one reactive group of the chemical bond agent to form a molecular structure where two reactive groups of the chemical bond agent are chemically bonded with each other.

Further, the reactive group at one terminal of the hydrophilic polymer is chemically bonded with one reactive group of chemical bond agent A and one reactive group of the chemical bond agent A is bonded with one reactive group of chemical bond agent B to form a molecular structure where two reactive groups of the chemical bond agent B are chemically bonded with each other. The chemical bond agent B may further react with the reactive group of the hydrophilic polymer to form a chemical bond.

In these molecular structures, only one terminal of the hydrophilic polymer is fixed with the chemical bond agent

and a hydrophilic site (site comprising hydrophilic repeating units other than the one terminal) of the hydrophilic polymer has a high degree of freedom and is excellent in mobility.

(Low molecular weight hydrophilic compound)

To the hydrophilic layer, a low molecular weight hydrophilic compound may be added. Examples of the low molecular weight hydrophilic compound include a glycol (for example, ethylene glycol, diethylene glycol, triethylene glycol, propylene glycol, dipropylene glycol or tripropylene glycol), an ether thereof, an aster thereof, a polyhydric alcohol (for example, glycerin or pentaerythritol), an amine (for example, triethanolamine, diethanolamine or monoethanolamine), a salt thereof, a sulfonic acid (for example, toluenesulfonic acid or benzenesulfonic acid), a salt thereof, a phosphonic acid (for example, phenylphophonic acid), a salt thereof, a carboxylic acid (for example, tartaric acid, oxalic acid, citric acid, malic acid, lactic acid, gluconic acid or an amino acid) and a salt thereof.

(Hydrophilicity-hydrophobicity converting agent)

According to the embodiment of a hydrophilic image-recording layer that can be changed to hydrophobic, the hydrophilic image-recording layer contains a hydrophilicity-hydrophobicity converting agent.
The hydrophilicity-hydrophobicity converting agent preferably includes thermoplastic particle, thermosetting particle or microcapsule of a compound (preferably a polymer) the physical property of which per se is changed from hydrophilic to hydrophobic upon heating or a hydrophobic compound.
The compound capable of changing from hydrophilic to hydrophobic is preferably a polymer having a functional group which causes decarboxylation upon heat to change from hydrophilic to hydrophobic (described in JP-A-2000-122272). It is preferable that a contact angle of water droplet in the air on a layer formed by coating the compound capable of changing from hydrophilic to hydrophobic is 20 degrees or less before heating and 65 degrees or more after the heating.
The hydrophobic compound constituting the thermoplastic particle or thermosetting particle is preferably a polymer. The polymer particle is preferably thermoplastic polymer particle, thermoreactive polymer particle or microcapsule containing a hydrophobic compound enmicrocapsulated.
The thermoplastic polymer particles are described in Research Disclosure, No. 33303, January 1992, JP-A-9-123387, JP-A-9-131850, JP-A-9-171249, JP-A-9-171250 and European Patent 931,647.
An average particle size of the thermoplastic polymer particle is preferably from 0.01 to 2.0 μm. The thermoplastic polymer particle can be synthesized by an emulsion polymerization, a suspension polymerization or a dissolution dispersion method (method wherein a monomer is dissolved in a water-insoluble organic solvent, the solution is mixed with an aqueous solution containing a dispersing agent to emulsify, then the emulsion is heated to solidified in the form of particle while evaporating the organic solvent).
The thermoreactive polymer particle is classified into a thermosetting polymer particle and a polymer particle having a thermoreactive group.
The thermosetting polymer includes a resin having a phenol skeleton, a urea resin, a melamine resin, an alkyd resin, an unsaturated polyester resin, a polyurethane resin and an epoxy resin. The resin having a phenol skeleton, melamine resin, urea resin and epoxy resin are preferable.
An average particle size of the thermosetting polymer particle is preferably from 0.01 to 2.0 μm. The thermosetting polymer particle can be synthesized by a dissolution dispersion method. Also, the polymer particle can be formed simultaneously with the synthesis of the thermosetting polymer.
The thermoreactive group of the polymer particle having a thermoreactive group includes a radical polymerizable group (for example, an acryloyl group, a methacryloyl group, a vinyl group or an allyl group), a cationic polymerizable group (for example, a vinyl group or a vinyloxy group), an addition reactive group (for example, an isocyanate group, a blocked isocyanate group, an epoxy group or a vinyloxy group) and a functional group having an active hydrogen atom which is a reaction partner (for example, an amino group, a hydroxy group or a carboxy group), a condensation reactive group (for example, a carboxy group) and a functional group which is a reaction partner (for example, a hydroxy group or an amino group), and a ring-opening addition reactive group (for example, an acid anhydride) and a functional group which is a reaction partner (for example, an amino group or a hydroxy group).
In the polymerization, the thermoreactive group can be introduced into the polymer particle.
In the case of introducing the thermoreactive group into the polymer particle by the polymerization, an emulsification polymerization or suspension polymerization of a monomer having the thermoreactive group is preferable. Examples of the monomer having the thermoreactive group include allyl methacrylate, allyl acrylate, vinyl methacrylate, vinyl acrylate, 2-(vinyloxy)ethyl methacrylate, p-vinyloxystyrene, p-[2-(vinyloxy)ethyl]styrene, glycidyl methacrylate, glycidyl acrylate, 2-isocyanatoethyl methacrylate and a blocked isocyanate thereof, 2-isocyanatoethyl acrylate and a blocked isocyanate thereof, 2-aminoethyl methacrylate, 2-aminoethyl acrylate, 2-hydroxyethyl methacrylate, 2-hydroxyethyl acrylate, acrylic acid, methacrylic acid, maleic anhydride, a difunctional acrylate and a difunctional methacrylate. The blocked isocyanate includes, for example, a blocked isocyanate with an alcohol.

Also, a copolymer between the monomer having the thermoreactive group and other monomer (for example, a monomer not having the thermoreactive group) may be used. Examples of the other monomer include styrene, an alkyl acrylate, an alkyl methacrylate, acrylonitrile and vinyl acetate.

The thermoreactive group may also be introduced by conducting a polymer reaction after the polymerization. With respect to the polymer reaction, there is described in WO96/34316.

An average particle size of the polymer particle having the thermoreactive group is preferably from 0.01 to 2.0 μm, more preferably from 0.05 to 2.0 μm, and most preferably from 0.1 to 1.0 μm.

The microcapsule acting as the hydrophilicity-hydrophobicity converting agent contains a hydrophobic compound enmicrocapsulated. It is preferred that the hydrophobic compound has a thermoreactive group. The thermoreactive group used is the same as that of the polymer particle having the thermoreactive group. Examples of the monomer having the thermoreactive group include a monomer having plural ethylenically unsaturated groups in addition to the monomers described for the polymer particle having the thermoreactive group. The monomer having plural ethylenically unsaturated groups includes an acrylate of polyhydric alcohol (for example, trimehtylolpropane triacrylate or pentaerythritol tetraacrylate), a methacrylate of polyhydric alcohol (for example, dipentaerythritol dimethacrylate), an itaconate of polyhydric alcohol (for example, ethylene glycol diitaconate), a malate of polyhydric alcohol (for example, ethylene glycol dimalate), and a polyvalent acrylamide (for example, methylene bisacrylamide) .

The microcapsule can be produced according to a known method. As the method for the production of microcapsule, a coacervation method (described in U.S. Patents 2,800,457 and 2,800,458), an interfacial polymerization method (described in U.S. Patent 3,287,154, JP-B-38-19574 (the term "JP-B" as used herein means an "examined Japanese patent publication") and JP-B-42-446), a polymer deposition method (described in U.S. Patents 3,418,250 and 3,660,304), a method of using an isocyanate polyol wall material (described in U.S. Patent 3,796,669), a method of using an isocyanate wall material (described in U.S. Patent 3,914,511), a method of using a urea-formaldehyde-type or urea-formaldehyde-resorcinol-type wall-forming material (described in U.S. Patens 4,001,140, 4,087,376 and 4,089,802), a method of using a melamine-formaldehyde resin or hydroxycellulose wall material (described in U.S. Patent 4,025,445), an in-situ method by monomer polymerization (described in JP-B-36-9163 and JP-B-51-9079), a spray drying method (described in British Patent 930,422 and U.S. Patent 3,111,407), or an electrolytic dispersion cooling method (described in British Patents 952,807 and 967,074) can be adopted.

As a dispersing agent for stably dispersing the microcapsule in an aqueous medium, a water-soluble polymer can be used. As the water-soluble polymer, a natural polymer (for example, a polysaccharide or protein), a semi-synthetic polymer (for example, a cellulose ether or starch derivative) or a synthetic polymer can be used. Examples of the polysaccharide include gum arabic and sodium alginate. Examples of the protein include casein and gelatin. Examples of the cellulose ether include carboxymethyl cellulose and methyl cellulose. Examples of the synthetic polymer preferably include a polymer having a hydrocarbon main chain (for example, polyvinyl alcohol and a modified product thereof, polyacrylamide and a derivative thereof or polyvinyl pyrrolidone). A copolymer may also be used. Examples of the copolymer include an ethylene/vinyl acetate copolymer, a styrene/maleic anhydride copolymer, an ethylene/maleic anhydride copolymer, an isobutylene/maleic anhydride copolymer, an ethylene/acrylic acid copolymer and a vinyl acetate/acrylic acid copolymer.

It is preferred that the water-soluble polymer does not react with the isocyanate compound or has an extremely low reactivity with the isocyanate. In the case of using the water-soluble polymer (for example, gelatin) having a high reactivity with the isocyanate compound, it is preferred that the reactive functional group is previously removed or blocked.

It is preferred that the microcapsule wall has a three-dimensional crosslinked structure and is swellable with a solvent. The wall material of microcapsule preferably includes polyurea, polyurethane, polyester, polycarbonate, polyamide, a copolymer thereof or a mixture thereof, more preferably polyurea, polyurethane, a copolymer thereof or a mixture thereof. Further, a compound having the thermoreactive group may be introduced into the microcapsule wall.

An average particle size of the microcapsule is preferably from 0.01 to 3.0 μm, more preferably from 0.05 to 2.0 μm, and most preferably from 0.10 to 1.0 μm.

An amount of the polymer particle or microcapsule added to the hydrophilic image-recording layer is preferably 50% by weight or more, more preferably from 70 to 98% by weight, based on the solid content of the image-recording layer.

In the case of incorporating the microcapsule into the hydrophilic image-recording layer, a solvent which dissolves the content enmicrocapsulated in the microcapsule and swells the wall material of the microcapsule can be added to a dispersing medium of the microcapsule. In the case of the microcapsule comprising polyurea or polyurethane wall, as the solvent, an alcohol (for example, methanol, ethanol, propanol or tert-butanol), an ether (for example, tetrahydrofuran, propylene glycol monomethyl ether, ethylene glycol diethyl ether or ethylene glycol monomethyl ether), an acetal, an ester (for example, methyl lactate, ethyl lactate or γ-butyl lactone), a ketone (for example, methyl ethyl ketone), a polyhydric alcohol, an amide (for example, dimethylformamide or N,N-dimethylacetamide), an amine or a fatty acid is preferably used. Two or more solvents may be used in combination.

An amount of the solvent added is preferably from 5 to 95% by weight, more preferably from 10 to 90% by weight, and most preferably from 15 to 85% by weight, based on the coating solution.

(Light-to-heat converting agent)

In the embodiment of a hydrophilic image-recording layer that can be changed to hydrophobic, it is preferred that the hydrophilic image-recording layer contains a light-to-heat converting agent.

The light-to-heat converting agent is a substance which has a function of absorbing light and converting the light energy to heat energy to generate heat. The light is preferably infrared light. In other words, the light-to-heat converting agent is preferably an infrared absorbing agent.

Pigment, dye or metallic fine particle capable of absorbing infrared light is preferably used as the light-to-heat converting agent. In the case of using a microcapsule as the particle, it is particularly preferred to use an infrared absorbing dye as the light-to-heat converting agent.

With respect to the infrared absorbing dye, there are described in Senryo Binran (Handbook of Dyes), compiled by The Society of Synthetic Organic Chemistry, Japan (1970), Kagaku Kogyo (Chemical Technology), May 1986, pages 45 to 51, "Kin-Sekigai Kyushu Shikiso" (Near-Infrared Absorbing Dyes), and 90-Nendai Kinousei Shikiso no Kaihatsu to Shijo Douko (Developments and Market Trends of Functional Dyes of the 90s), Chapter 2, Item 2.3, CMC Publishing Co., Ltd. (1990) . Preferred examples of the infrared absorbing dye include azo dyes, metal complex azo dyes, pyrazolone azo dyes, naphthoquinone dyes (described in JP-A-58-112793, JP-A-58-224793, JP-A-59-48187, JP-A-59-73996, JP-A-60-52940 and JP-A-60-63744), anthraquinone dyes, phthalocyanine dyes (described in JP-A-11-235883), squarylium dyes (described in JP-A-58-112792), pyrylium dyes (described in U.S. Patents 3,881,924 and 4,283,475, JP-A-57-142645, JP-A-58-181051, JP-A-58-220143, JP-A-59-41363, JP-A-59-84248, JP-A-59-84249, JP-A-59-146063, JP-A-59-146061, JP-B-5-13514 and JP-B-5-19702), carbonium dyes, quinoneimine dyes, and methine dyes (described in JP-A-58-173696, JP-A-58-181690 and JP-A-58-194595).

With respect to the infrared absorbing dye, there are also described in U.S. Patents 4,756,993 and 5,156,938, JP-A-10-268512 and JP-A-2004-306582. Commercially available infrared absorbing dyes (for example, Epolight III-178, Epolight III-130 and Epolight III-125, produced by Epolin Inc.) may also be used.

The light-to-heat converting agent may be encapsulated in the microcapsule.

An amount of the light-to-heat converting agent added is preferably from 0.001 to 50% by weight, more preferably from 0.005 to 30% by weight, and most preferably from 0.01 to 10% by weight, based on the total solid content of the hydrophilic image-recording layer.

(Polymerization initiator)

In order to polymerize a polymerizable compound, a polymerization initiator can be used.

The polymerization initiator means a compound which generates a radical by energy of light, heat or both thereof to initiate and promote polymerization of a compound having a polymerizable unsaturated group. As the polymerization initiator, for example, a known heat-polymerization initiator or a compound having a bond of a small bond dissociation energy can be selected to use.

The compound which generates a radical is preferably a compound (heat radical generator) which generates a radical by heat energy to initiate and promote polymerization of a compound having a polymerizable unsaturated group. As the heat radical generator, a known heat-polymerization initiator or a compound having a bond of a small bond dissociation energy can be appropriately selected to use.

Two or more compounds which generate a radical may be used in combination.

The compounds which generate a radical are described in JP-A-2004-306582. Examples of the compound which generates a radical include halogenated organic compounds, carbonyl compounds, organic peroxides, azo polymerization initiators, azide compounds, metallocene compounds, hexaarylbiimidazole compounds, organic boric acid compounds, disulfonic acid compounds, oxime ester compounds, and Onium salt compounds. Onium salts are most preferable.

[Support]

As the support, paper, a polymer (for example, cellulose ester, polyester, polyethylene, polystyrene, polypropylene, polycarbonate or polyvinyl acetal) film, a metal (for example, aluminum, zinc or copper) plate, paper laminated with polymer, paper deposited with metal or a polymer film deposited with metal can be used. The polymer film and metal plate are preferable, the polyester film and aluminum plate are more preferable, and the aluminum plate is most preferable.

The aluminum plate is a pure aluminum plate or an aluminum alloy plate. The hetero element contained in the

aluminum alloy includes, for example, silicon, iron, manganese, copper, magnesium, chromium, zinc, bismuth, nickel and titanium. The content of the hetero element in the aluminum alloy is 10% by weight or less.

A thickness of the aluminum plate is preferably from 0.1 to 0.8 mm, more preferably from 0.15 to 0.6 mm, and most preferably from 0.2 to 0.4 mm.

The aluminum plate is preferably subjected to surface roughening treatment.

For instance, the surface of aluminum plate is mechanically scraped, for example, by a sand blast process or a brush process to form depressions so that a roughened surface can be provided.

The aluminum plate is preferably subjected to surface roughening treatment. Prior to the surface roughening treatment of the aluminum plate, a degreasing treatment may be conducted for removing rolling oil on the surface thereof. The degreasing treatment can be carried out using a surfactant, an organic solvent or an aqueous alkaline solution.

The roughening treatment includes mechanical roughening treatment, electrochemical roughening treatment and chemical roughening treatment.

The mechanical roughening treatment includes ball grinding, brush grinding, blast grinding and buff grinding.

The electrochemical roughening treatment can be conducted by passing alternating current or direct current in an electrolyte containing an acid (for example, hydrochloric acid or nitric acid). Also, a method of using a mixed acid (described in JP-A-54-63902) can be adopted.

Also, a transfer method where a concavo-convex form is transferred using a roll provided with concavity and convexity at the rolling stage of aluminum plate can be performed. The concavity and convexity can also be provided with a mechanical embossing process. Further, convex portion may be provided on the surface by gravure printing or the like to form a roughened surface. A layer containing solid fine particle (matting agent) is provided on the surface of support by means of coating or printing to form a roughened surface. The solid fine particle can be incorporated into a polymer film at the production of the polymer film to form concavity and convexity on the surface of polymer film. A roughened surface is also formed by solvent treatment, corona discharge treatment, plasma treatment, electron beam irradiation treatment or x-ray irradiation treatment. The above-described means may be used in combination. The means for forming a roughened surface by a sand blast process or printing of resin and the means for forming concavity and convexity by incorporating solid fine particle are particularly preferable.

The aluminum plate subjected to the roughening treatment is preferably subjected to an alkali etching treatment and further subjected to a neutralizing treatment.

The aluminum plate is preferably subjected to anodizing treatment.

As the electrolyte used for the anodizing treatment of the aluminum plate, various electrolytes capable of forming porous oxide film can be used. Ordinarily, sulfuric acid, hydrochloric acid, oxalic acid, chromic acid or a mixed acid thereof is used. The concentration of the electrolyte can be appropriately determined depending on the kind of the electrolyte used.

Preferable conditions for the anodizing treatment are that electrolyte concentration in the solution is from 1 to 80% by weight, liquid temperature is from 5 to 70°C, current density is from 5 to 60 A/$dm^2$, voltage is from 1 to 100 V, and electrolysis time is from 10 seconds to 5 minutes. An amount of the anodized film formed is preferably from 1.0 to 5.0 g/$m^2$ and more preferably from 1.5 to 4.0 g/$m^2$.

After conducting the anodizing treatment, the surface of the aluminum plate may be subjected to a hydrophilizing treatment, if desired, in order to improve adhesion to the hydrophilic layer or the like. The hydrophilizing treatment includes an alkali metal silicate method described in U.S. Patents 2,714,066, 3,181,461, 3,280,734 and 3,902,734. In the method, the support is subjected to immersion treatment or electrolytic treatment in an aqueous solution, for example, of sodium silicate. In addition, the hydrophilizing treatment includes, for example, a method of treating with potassium fluorozirconate described in JP-B-36-22063 and a method of treating with polyvinylphosphonic acid described in U.S. Patents 3,276,868, 4,153,461 and 4,689,272.

[Other layers]

An undercoat layer may be provided between the support and the hydrophilic layer.

A protective layer may be provided on the hydrophilic image-recording layer.

[Lithographic printing plate precursor]

According to the embodiment including the hydrophilic image-recording layer, a lithographic printing plate precursor comprising a support and the hydrophilic image-recording layer is utilized in printing.

More specifically, a partial region of the hydrophilic image-recording layer of the lithographic printing plate precursor comprising a support and the hydrophilic image-recording layer is converted to a hydrophobic region in response to an image to prepare a lithographic printing plate having the hydrophilic region and the hydrophobic region on the surface of image-recording layer, and dampening water and oily ink are supplied to the lithographic printing plate so that

printing is performed under the condition of attaching from 0.1 to 2 g/m$^2$ of the dampening water on the hydrophilic region and attaching the oily ink on the hydrophobic region.

According to the embodiment wherein the hydrophilic layer and a support construct the hydrophilic substrate, a lithographic printing plate precursor is obtained by providing an image-recording layer on the hydrophilic layer.

The image-recording layer is classified into a positive type where the solubility thereof in an alkali aqueous solution increases upon exposure and a negative type where the solubility thereof in an alkali aqueous solution decreases vice versa upon exposure. Both of the positive type and negative type are known. When the unexposed area or exposed area of the image-recording layer can be removed with oily ink or dampening water, it is also possible that the lithographic printing plate precursor is directly mounted on a printing machine to perform printing without conducting development processing (treatment for removing the unexposed area or exposed area of the image-recording layer) after the exposure. Such types of image-recording layers are also variously proposed. To the hydrophilic substrate according to the invention, any of these image-recording layers can be applied. Among them, the image-recording layer capable of being removed with ink and/or dampening water is preferably used.

More specifically, a partial region of the image-recording layer is removed in response to an image from the lithographic printing plate precursor comprising the hydrophilic substrate having a hydrophilic layer and a support and the image-recording layer provided on the hydrophilic layer to prepare a lithographic printing plate comprising a hydrophilic region composed of the hydrophilic layer revealed and a hydrophobic region composed of the remaining image-recording layer, and dampening water and oily ink are supplied to the lithographic printing plate so that printing is performed under the condition of attaching from 0. 1 to 2 g/m$^2$ of the dampening water on the hydrophilic region and attaching the oily ink on the hydrophobic region.

The image-recording layer provide on the hydrophilic layer can contain thermoplastic particle, thermosetting particle or microcapsule of a compound (preferably a polymer) the physical property of which per se is changed from hydrophilic to hydrophobic upon heating or a hydrophobic compound. The detail thereof is same as that of the hydrophilicity-hydrophobicity converting agent added to the hydrophilic image-recording layer.

The image-recording layer may contain a light-to-heat converting agent, a polymerization initiator and a polymerizable compound. The details of the light-to-heat converting agent, polymerization initiator and polymerizable compound are also same as those of the light-to-heat converting agent, polymerization initiator and polymerizable compound capable of adding to the hydrophilic image-recording layer.

It is also possible to prepare a lithographic printing plate by directly forming a hydrophobic region (for example, applying imagewise hydrophobic oil droplets by an inkjet system or forming a hydrophobic toner image by an electrophotographic recording system) on the hydrophilic layer.

More specifically, a hydrophobic substance is attached to the hydrophilic substrate having the hydrophilic layer and a support in response to an image to prepare a lithographic printing plate comprising a hydrophilic region composed of the surface of hydrophilic layer and a hydrophobic region attached with the hydrophobic substance, and dampening water and oily ink are supplied to the lithographic printing plate so that printing is performed under the condition of attaching from 0.1 to 2 g/m$^2$ of the dampening water on the hydrophilic region and attaching the oily ink on the hydrophobic region.

## EXAMPLES

The present invention will be described in more detail with reference to the following examples, but the invention should not be construed as being limited thereto.

### EXAMPLE 1

(Preparation of aluminum support)

A 0.24-mm thick aluminum plate (1050 material) was grained on the surface thereof using a nylon brush and an aqueous suspension containing 400-mesh pumice stone, and then thoroughly washed with water. The plate was immersed in a 15% by weight aqueous solution of sodium hydroxide to conduct etching, followed by washing with water. The plate was further neutralized with a 1% by weight aqueous solution of nitric acid, and then subjected to the electrolytic surface roughening treatment in a 0.7% by weight aqueous solution of nitric acid at an anodic time electricity of 160 Coulomb/dm$^2$ using a current having a rectangular alternating wave form. After washing with water, the plate was immersed in a 10% by weight aqueous solution of sodium hydroxide to conduct etching, followed by washing with water. Subsequently, the plate was immersed in a 30% by weight aqueous solution of sulfuric acid to desmut, followed by washing with water. Then, the plate was subjected to anodizing treatment in a 20% by weight aqueous solution of sulfuric acid using direct current to form an anodic oxide film of 2.7 g/m$^2$. Further, the plate was treated with a 0.5% by weight aqueous solution of sodium silicate at 30°C for 10 seconds, whereby an aluminum support was prepared. The surface

roughness of the aluminum support was 0.45 μm in terms of center line average roughness (Ra).

(Formation of undercoat layer)

A coating solution having the composition shown below was prepared and coated on the above-described aluminum support so as to have a thickness of 0.5 g/m$^2$, followed by drying at 100°C for one minute to form an undercoat layer.

Coating Solution for Undercoat Layer

| | |
|---|---|
| Methanol silica (30% by weight methanol dispersion, produced by Nissan Chemical Industries, Ltd.) Isopropyl alcohol 200 g | 40 g |

(Preparation of sol-gel solution)

With a mixture of 200 g of ethyl alcohol, 10 g of acetylacetone, 10 g of tetraethyl orthotitanate and 1,000 g of purified water were mixed 100 g of tetramethoxysilane (produced by Tokyo Chemical Industry Co., Ltd.) and 35 g of Hydrophilic polymer (1) having a functional group corresponding to a silane coupling agent at the terminal thereof at 60°C while mixing for 2 hours. Then, the mixture was gradually cooled to room temperature to prepare a sol-gel solution.

Hydrophilic polymer (1):

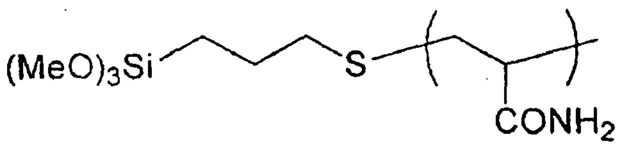

(Formation of hydrophilic layer)

A coating solution having the composition shown below was prepared, dispersed in a paint shaker for 10 minutes, and coated on the undercoat layer by a bar coater so as to have a dry coating layer weight of 3.0 g/m$^2$, followed by drying at 100°C for 10 minutes in an oven to form a hydrophilic layer, whereby a hydrophilic substrate was prepared.

Coating Solution for Hydrophilic Layer

| | |
|---|---|
| Silica (Sylysia 310, particle size: 1.4 μm, surface area: 300 m$^2$/g, produced by Fuji Silysia Chemical Ltd.) | 10 g |
| Carboxymethyl cellulose | 1.0 g |
| Sol-gel solution | 650 g |
| 20% by weight aqueous solution of colloidal silica (Snowtex C, produced by Nissan Chemical Industries, Ltd.) | 90 g |
| 5% by weight aqueous solution of anionic surfactant (sodium di-2-ethylhexyl glutarate-2-sulfonate) | 20 g |
| Purified water | 400 g |

EXAMPLES 2 TO 6

Hydrophilic substrates were prepared in the same manner as in Example 1 except for using particles described in Table 1 shown below in place of the silica used in Example 1, respectively.

EXAMPLES 7

A coating solution having the composition shown below was coated by a bar on the aluminum support prepared

in Example 1, followed by drying at 140°C for 10 minutes in an oven to form a hydrophilic layer having a dry coating amount of 2.0 g/$m^2$, whereby a hydrophilic substrate was prepared.

Coating Solution for Hydrophilic Layer

| | |
|---|---|
| Water | 2,500 g |
| Silica (P-527, particle size: 1.6 μm, surface area: 55 $m^2$/g, produced by Mizusawa industrial Chemicals, Ltd.) | 2 g |
| Carboxymethyl cellulose | 0.2 g |
| Polyacrylic acid (weight average molecular weight: 100,000) | 20 g |
| Hydrophilic polymer (2) having a reactive group at the terminal thereof | 60 g |
| Crosslinking agent (1) shown below | 25 g |
| 5% by weight aqueous solution of surfactant (sodium diethylhexyl sulfosuccinate) | 20 g |

Hydrophilic polymer (2):

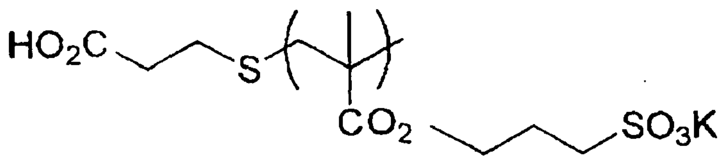

Crosslinking agent (1):

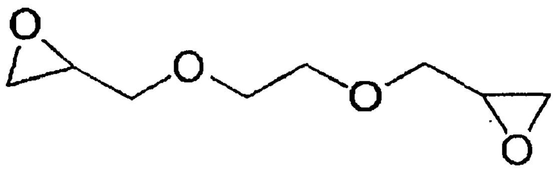

EXAMPLES 8

A coating solution having the composition shown below was coated by a bar on the aluminum support prepared in Example 1, followed by drying at 100°C for 10 minutes in an oven to form a hydrophilic layer having a dry coating amount of 5.0 g/$m^2$, whereby a hydrophilic substrate was prepared.

Coating Solution for Hydrophilic Layer

| | |
|---|---|
| Water | 1,500 g |
| Starch modified with carboxylic acid | 100 g |
| Silica (Sylysia 350, particle size: 1.8 μm, surface area: 300 $m^2$/g, produced by Fuji Silysia Chemical Ltd.) | 20 g |
| Glyoxal (aqueous solution having solid content of 40% by weight) | 50 g |
| 5% by weight aqueous solution of surfactant (sodium diethylhexyl sulfosuccinate) | 20 g |

EXAMPLE 9

A hydrophilic substrate was prepared in the same manner as in Example 1 except for using a polyethylene terephthalate film having a thickness of 0.24 mm subjected to corona discharge treatment on the surface thereof in place of the aluminum support used in Example 1.

(Measurement of moisture absorption amount of hydrophilic layer)

Weight (B1) of the aluminum support provided with the undercoat layer prepared in Example 1 after humidity conditioning under an environment of 25°C temperature and 10% humidity for one hour, weight (A1) of each of the hydrophilic supports prepared in Examples 1 to 8 after humidity conditioning under the environment of 25°C temperature and 10% humidity for one hour, weight (B2) of the aluminum support provided with the undercoat layer prepared in Example 1 after humidity conditioning under an environment of 25°C temperature and 90% humidity for one hour, and weight (A2) of each of the hydrophilic supports prepared in Examples 1 to 8 after humidity conditioning under the environment of 25°C temperature and 90% humidity for one hour were measured. The difference of [(A2) - (B2)] - [(A1) - (B1)] was regarded as the amount of moisture absorbed in the hydrophilic layer, and a ratio (%) of the moisture adsorption amount to weight per $m^2$ of the hydrophilic layer was calculated.
The results are shown in Table 1 below.

(Measurement of moisture absorption amount of hydrophilic particle)

Weighing about one g of the hydrophilic particle each used in Examples 1 to 9, and weight (P1) of the hydrophilic particle after humidity conditioning under an environment of 25°C temperature and 10% humidity for one hour and weight (P2) of the hydrophilic particle after humidity conditioning under an environment of 25°C temperature and 90% humidity for one hour were measured respectively. A ratio (%) of the amount of moisture adsorbed in the hydrophilic particle was calculated from [(P2)-(P1)]/(P1).
The results are shown in Table 1 below.

(Evaluation of printing stain)

A solid image was formed on each of the support for lithographic printing plate by an oily magic marker and the support for lithographic printing plate was mounted on a cylinder of sheet-feed printing machine (DAIYA1F-2, produced by Mitsubishi Heavy Industries, Ltd.). After supplying dampening water (EU-3 (etching solution, produced by Fuji Photo Film Co., Ltd.)/water/isopropyl alcohol = 1/89/10 (volume ratio)) and ink (TRANS-G (N) black ink (produced by Dainippon Ink and Chemicals, Inc.), 100 sheets of printing was conducted at printing speed of 7,200 sheets per hour. Subsequently, evaluation of ink and water balance was conducted by changing water scale, and the water scale at which background stain occurred was determined. Further, the ink was attached on the whole surface of the printing plate and then the dampening water was supplied thereon to evaluate a number of sheets necessary for removing the ink. As the value of the water scale at which background stain occurred is small, the support is evaluated as excellent in hydrophilicity to hardly form stain even in a small amount of the dampening water. As the value of the number of sheets necessary for removing the ink is small, the support is evaluated as excellent in hydrophilicity to hardly form stain.
The results are shown in Table 1 below.

TABLE 1

| Hydrophilic Substrate | Hydrophilic Particle (surface area) | Moisture Adsorption Amount of Hydrophilic Particle (%) | Moisture Adsorption Amount of Hydrophilic Layer (%) | Water Scale at Occurrence of Background Stain | Number of Sheets Necessary for Removing Ink |
|---|---|---|---|---|---|
| Example 1 | Silica (300 $m^2$/g) | 25 | 7 | 30 | 15 |
| Example 2 | Silica (500 $m^2$/g) | 70 | 10 | 35 | 20 |
| Example 3 | Silica (700 $m^2$/g) | 90 | 20 | 40 | 25 |

(continued)

| Hydrophilic Substrate | Hydrophilic Particle (surface area) | Moisture Adsorption Amount of Hydrophilic Particle (%) | Moisture Adsorption Amount of Hydrophilic Layer (%) | Water Scale at Occurrence of Background Stain | Number of Sheets Necessary for Removing Ink |
|---|---|---|---|---|---|
| Example 4 | Silica (40 $m^2/g$) | 15 | 5 | 30 | 10 |
| Example 5 | Alumina (300 $m^2/g$) | 20 | 10 | 30 | 15 |
| Example 6 | Titanium Oxide (4 $m^2/g$) | 5 | 5 | 30 | 15 |
| Example 7 | Silica (55 $m^2/g$) | 15 | 20 | 30 | 15 |
| Example 8 | Silica (300 $m^2/g$) | 25 | 25 | 35 | 20 |
| Example 9 | Silica (300 $m^2/g$) | 25 | 40 | 35 | 15 |

<u>EXAMPLES 10 TO 18</u>

(Preparation of photosensitive solution)

A photosensitive solution having the composition shown below was prepared.

| | |
|---|---|
| Photosensitive Solution (1) | |
| Binder polymer (4) | 16 g |
| Polymerization initiator (2) | 10 g |
| Infrared absorbing agent (1) | 2 g |
| Polymerizable monomer (Aronix M-215, produced by Toagosei Co., Ltd.) | 30 g |
| Polymerizable monomer (Phosmer PE, produced by Uni-Chemical Co., Ltd) | 10 g |
| Fluorine-containing surfactant (1) | 4 g |
| Methyl ethyl ketone | 110 g |
| 1-Methoxy-2-propanol | 860 g |

Binder polymer (4):

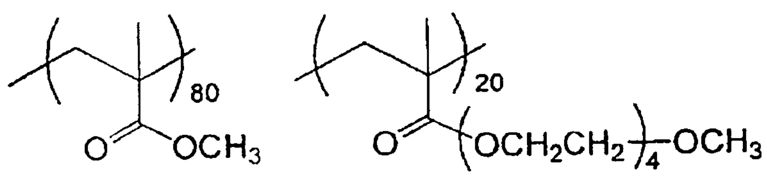

Polymerization initiator (2):

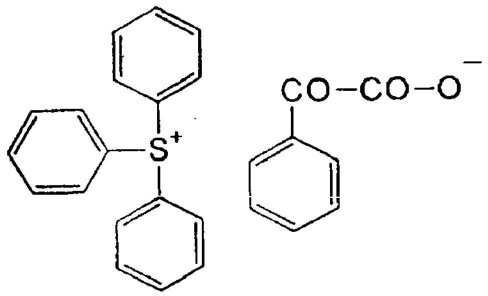

Infrared absorbing agent (1):

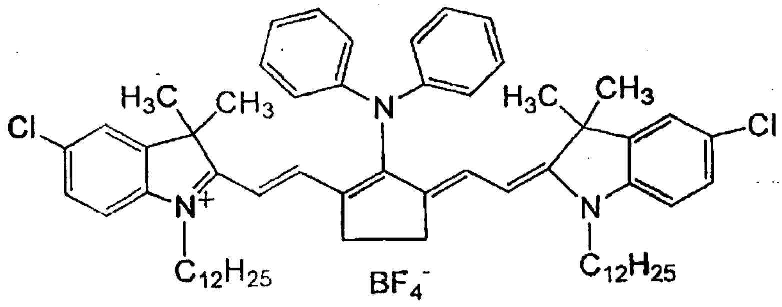

Fluorine-containing surfactant (1):

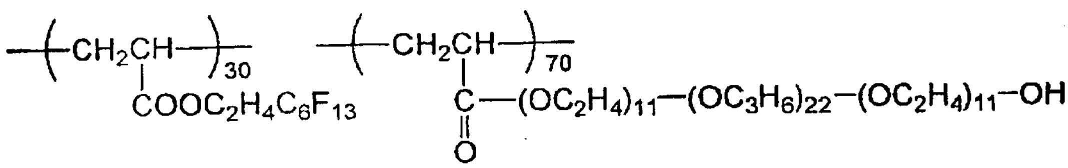

(Preparation of microcapsule dispersion)

An oil phase component was prepared by dissolving 10 g of adduct of trimethylol propane and xylene diisocyanate (Takenate D-110N, produced by Mitsui Takeda Chemical Co., Ltd. , 75% by weight ethyl acetate solution), 6.00 g of ethylenically unsaturated monomer (Aronix M-215, produced by Toagosei Co., Ltd.) and 0.12 g of surfactant (Pionine A-41C, produced by Takemoto Oil and Fat Co., Ltd.) in 16.67 g of ethyl acetate.

As an aqueous phase component, 37.5 g of a 4% by weight aqueous solution of polyvinyl alcohol (PVA-205, produced by Kuraray Co., Ltd.) was prepared.

The oil phase component and the aqueous phase component were mixed and emulsified using a homogenizer at 12,000 rpm for 10 minutes. The resulting emulsion was added to 25 g of distilled water and stirred at room temperature for 30 minutes and then at 40°C for 2 hours. The thus obtained microcapsule liquid was diluted using distilled water so as to have the solid concentration of 15% by weight. The average particle size of the microcapsule was 0.2 μm.

(Preparation of microcapsule solution)

A microcapsule solution having the composition shown below was prepared.

Microcapsule Solution

| | |
|---|---|
| Microcapsule dispersion described above | 260 g |
| Water | 240 g |

(Formation of image-recording layer)

The photosensitive solution and the microcapsule solution were mixed and stirred to prepare a coating solution for image-recording layer. The coating solution just after the preparation was coated on each of the hydrophilic substrates prepared in Examples 1 to 9 using a bar. The coated layer was dried at 100°C for 60 seconds using an oven to prepare an image-recording layer having a dry coating amount of 1.0 g/$m^2$.

(Preparation of inorganic particle dispersion)

To 193.6 g of ion exchanged water was added 6.4 g of synthetic mica (Somasif ME-100, produced by CO-OP Chemical Co. , Ltd.) and the mixture was dispersed using a homogenizer until an average particle size (measured according to a laser scattering method) became 3 μm. An aspect ratio of the inorganic particle dispersed was 100 or more.

(Preparation of lithographic printing plate precursor of on-machine development type)

A coating solution for protective layer having the composition shown below was coated on the image-recording layer using a bar and dried at 120°C for 60 seconds using an oven to prepare a protective layer having a dry coating amount of 0.15 g/$m^2$.

Thus, a lithographic printing plate precursor of on-machine development type was prepared.

Coating Solution for Protective Layer

| | |
|---|---|
| Inorganic particle dispersion (1) | 150 g |
| Polyvinyl alcohol (PVA-105, produced by Kuraray Co., Ltd., saponification degree: 98.5% by mole, polymerization degree: 500) | 6 g |
| Polyvinyl pyrrolidone (K30, produced by Tokyo Chemical Industry Co., Ltd., weight average molecular weight: 40,000) | 1 g |
| Vinyl pyrrolidone/vinyl acetate copolymer (Luvitec VA64W, produced by ICP Co., Ltd., copolymerization ratio = 6/4) | 1 g |
| Nonionic surfactant (Emalex 710 produced by Nihon-Emulsion Co., Ltd.) | 1 g |
| Ion exchanged water | 600 g |

(Evaluation of printing)

Each of the lithographic printing plate precursors obtained was exposed by Trendsetter 3244VX, produced by Creo Co., equipped with a water-cooled 40 W infrared semiconductor laser under the conditions of a power of 9 W, a rotational number of an outer surface drum of 210 rpm and a resolution of 2,400 dpi. The exposed image contained a fine line chart.

The exposed lithographic printing plate precursor was mounted without conducting development processing on a plate cylinder of a printing machine (SOR-M, produced by Heidelberg) . After supplying dampening water (EU-3 (etching solution, produced by Fuji Photo Film Co. , Ltd.) /water/isopropyl alcohol = 1/89/10 (volume ratio)) and ink (TRANS-G (N) black ink (produced by Dainippon Ink and Chemicals, Inc.), 2,000 sheets of printing was conducted at a printing speed of 6,000 sheets per hour.

A number of printing papers required until on-machine development of the unexposed area of the image-recording layer on the printing machine was completed to reach a state where the ink was not transferred to the printing paper in the non-image area was measured as on-machine development property, and obtained result was 20 sheets. In the case of using any of the lithographic printing plate precursors, prints without stain in the non-image area were obtained within the printing of 2,000 sheets.

EXAMPLE 19

(Preparation of lithographic printing plate precursor of non-development type)

Microcapsule solution prepared in Example 10 was added to the coating solution for hydrophilic layer described in Example 1 so as to have 50% by weight based on the total solid content of the coating solution for hydrophilic layer in terms of solid content. The coating solution thus-prepared was coated on the undercoat layer of the aluminum support and dried in the same manner as in Example 1 to prepare a hydrophilic image-recording layer. Thus, a lithographic printing plate precursor of non-development type was prepared.

(Evaluation of printing)

The lithographic printing plate precursor obtained was exposed imagewise, mounted without conducting any processing on the plate cylinder of printing machine, supplied with the dampening water and ink, and conducted printing of 2,000 sheets at a printing speed of 6,000 sheets per hour, in the same manner as in Example 10. Prints without stain in the non-image area were obtained within the printing of 2,000 sheets.

EXAMPLES 20 TO 28

(Preparation of resin particle)

A mixed solution of 14 g of poly(dodecyl methacrylate), 100 g of vinyl acetate, 4.0 g of octadecyl methacrylate and 286 g of Isopar H was heated to temperature of 70°C with stirring under nitrogen gas stream. To the solution was added 1.5 g of 2,2'-azobis(isovaleronitrile) as a polymerization initiator, followed by reacting for 4 hours. Then, 0.8 g of 2,2'-azobis(isovaleronitrile) was added to the reaction mixture and the mixture was heated to temperature of 80°C, followed by reacting for 2 hours, and 0.6 g of 2,2'-azobis(isovaleronitrile) was added thereto, followed by reacting for 2 hours. The temperature of the reaction mixture was raised to 100°C, followed by stirring for one hour, thereby distilling off the unreacted monomers. After cooling the reaction mixture, it was passed through a nylon cloth of 200 mesh. The resulting white dispersion was a latex having a polymerization rate of 93% and an average particle size of 0.35 μm. The particle size was determined using CAPA-500 (manufactured by Horiba Ltd.)

(Preparation of oily ink)

In a paint shaker (produced by Toyo Seiki Co., Ltd.), 10 g of dodecyl methacrylate/acrylic acid copolymer (copolymerization ratio: 98/2 by weight), 10 g of Alkali Blue and 30 g of Shellsol 71 were dispersed together with glass beads for 4 hours to prepare a fine blue dispersion of Alkali Blue.

A mixture of 50 g (as a solid content) of the above-described resin particle, 5 g (as a solid content) of the above-described blue dispersion of Alkali Blue and 0.06 g of zirconium naphthenate was diluted with one liter of Isopar G to prepare blue oily ink.

(Preparation of lithographic printing plate precursor by inkjet system)

A servo plotter (DA8400, produced by Graphtec Corp.) able to write by an output from a personal computer was converted so that an ink discharge head was mounted on a pen plotter section, and each of the hydrophilic substrates prepared in Examples 1 to 9 was placed on a counter electrode positioned at a distance of 1.5 mm from the ink discharge head. Printing was performed on the hydrophilic substrate using the above-described oily ink to make a plate. The aluminum support of the hydrophilic substrate was electrically connected with the counter electrode using silver paste at the plate making.

The plate was heated for 10 seconds using a Ricoh Fuser (produced by Ricoh Co., Ltd.) so as to adjust the surface temperature of the plate to 70°C, thereby fixing the ink image. The image formed on the plate was visually observed under an optical microscope of 200 magnifications for evaluation. The image formed on each of the plates was clear without the occurrence of blur or disappearance of fine lines and fine letters.

(Evaluation of printing)

Using each of the lithographic printing plates obtained, the evaluation of printing was made in the same manner as in Example 10. 2,000 sheets of prints without stain in the non-image area were obtained.

This application is based on Japanese Patent application JP 2005-198859, filed July 7, 2005, the entire content

of which is hereby incorporated by reference, the same as if set forth at length.

## Claims

1. A hydrophilic substrate comprising: a hydrophilic layer; and a support, wherein the hydrophilic layer contains a hydrophilic particle having a surface area of from 1 to 1,000 $m^2/g$.

2. The hydrophilic substrate as claimed in claim 1, wherein the hydrophilic particle has a surface area of from 2 to 700 $m^2/g$.

3. The hydrophilic substrate as claimed in claim 1, wherein a moisture adsorption amount of the hydrophilic particle is 100% by weight or less at relative humidity of 90%.

4. The hydrophilic substrate as claimed in claim 1, wherein a moisture adsorption amount of the hydrophilic particle is 70% by weight or less at relative humidity of 90%.

5. The hydrophilic substrate as claimed in claim 1, wherein a moisture adsorption amount of the hydrophilic layer is 100% by weight or less at relative humidity of 90%.

6. The hydrophilic substrate as claimed in claim 1, wherein a moisture adsorption amount of the hydrophilic layer is 80% by weight or less at relative humidity of 90%.

7. A lithographic printing plate precursor comprising:

   the hydrophilic substrate as claimed in claim 1, wherein the hydrophilic layer contains a hydrophilicity-hydrophobicity converting agent which functions upon acceptance of light or heat energy.

8. A lithographic printing plate precursor comprising:

   an image-recording layer capable of being removed with at least one of ink and dampening water; and the hydrophilic substrate as claimed in claim 1.

9. A lithographic printing method comprising:

   attaching a hydrophobic substance onto the hydrophilic substrate as claimed in claim 1 in response to an image to prepare a lithographic printing plate comprising a hydrophilic region composed of a hydrophilic surface of the hydrophilic substrate and a hydrophobic region composed of the hydrophobic substance attached; and
   supplying dampening water and ink to the lithographic printing plate to conduct printing.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 59101651 A
- JP 8292558 A
- JP 9218507 A
- JP 8272087 A
- JP 8192579 A
- JP 5254251 A
- JP 2003175683 A
- JP 2000122272 A
- JP 9123387 A
- JP 9131850 A
- JP 9171249 A
- JP 9171250 A
- EP 931647 A
- WO 9634316 A
- US 2800457 A
- US 2800458 A
- US 3287154 A
- JP 3819574 B
- JP 42446 B
- US 3418250 A
- US 3660304 A
- US 3796669 A
- US 3914511 A
- US 4025445 A
- JP 369163 B
- JP 51009079 B
- GB 930422 A
- US 3111407 A
- GB 952807 A
- GB 967074 A
- JP 58112793 A
- JP 58224793 A
- JP 59048187 A
- JP 59073996 A
- JP 60052940 A
- JP 60063744 A
- JP 11235883 A
- JP 58112792 A
- US 3881924 A
- US 4283475 A
- JP 57142645 A
- JP 58181051 A
- JP 58220143 A
- JP 59041363 A
- JP 59084248 A
- JP 59084249 A
- JP 59146063 A
- JP 59146061 A
- JP 5013514 B
- JP 5019702 B
- JP 58173696 A
- JP 58181690 A
- JP 58194595 A
- US 4756993 A
- US 5156938 A
- JP 10268512 A
- JP 2004306582 A
- JP 54063902 A
- US 2714066 A
- US 3181461 A
- US 3280734 A
- US 3902734 A
- JP 3622063 B
- US 3276868 A
- US 4153461 A
- US 4689272 A
- JP 2005198859 A


### Non-patent literature cited in the description


- **OTSU et al.** *Macromolecules,* 1986, vol. 19, 2087
- *Research Disclosure,* January 1992
- Senryo Binran. 1970
- Kagaku Kogyo. May 1986, 45-51
- Kin-Sekigai Kyushu Shikiso. 90-Nendai Kinousei Shikiso no Kaihatsu to Shijo Douko (Developments and Market Trends of Functional Dyes of the 90s). CMC Publishing Co., Ltd, 1990